# EUROPÄISCHE PATENTSCHRIFT

(11) **EP 0 602 496 B1**
(45) Veröffentlichungstag und Bekanntmachung des Hinweises auf die Patenterteilung: **19.03.1997**
(21) Anmeldenummer: 93119637.2
(22) Anmeldetag: 06.12.1993
(51) Int. Cl.: H03K 19/0175, H03K 19/003, H03K 17/08

(54) **Tristate-fähige Treiberschaltung**
Tristate-capable driver circuit
Circuit d'attaque capable de prendre trois états

(30) Priorität: 14.12.1992 DE 4242152
(43) Veröffentlichungstag der Anmeldung: 22.06.1994
(73) Patentinhaber: SIEMENS AKTIENGESELLSCHAFT, 80333 München (DE)
(72) Erfinder: Berthold, Jörg, Dr., D-81675 München (DE); Nebel, Gerhard, D-87509 Immenstadt (DE); Schmitt-Landsiedel, Doris, Dr., D-85521 Ottobrunn (DE)

(56) Entgegenhaltungen:
- EP-A- 0 196 113
- EP-A- 0 332 077
- EP-A- 0 383 554
- EP-A- 0 490 243
- GB-A- 2 249 444
- US-A- 4 703 203
- US-A- 5 001 365
- PATENT ABSTRACTS OF JAPAN, Bd. 11, Nr. 209 (E-521) (2656) 7. Juli 1987 & JP-A-62 029 316
- IBM TECHNICAL DISCLOSURE BULLETIN, Bd.34, Nr.2, Juli 1991 Seiten 427 - 429 'BiCMOS Tristate 3V LVTTL 5V Compatible Off-Chip Driver'

## Beschreibung

Die vorliegende Erfindung betrifft eine Tristate-fähige Treiberschaltung nach dem Oberbegriff des Patentanspruchs 1.

Eine Tristate-fähige Treiberschaltung der gattungsgemäßen Art ist beispielsweise aus der US-Patentschrift 4,725,982 (Hara et al, Tri-State-Buffer Circuit) bekannt. Dabei handelt es sich um eine Tristate-fähige Treiberschaltung mit einer Auswahlschaltung, einer ersten und einer zweiten Ansteuerschaltung sowie einem ersten und zweiten Bipolartransistor am Treiberausgang. Diese Treiberschaltung benötigt nur wenig Chipfläche und ist gleichzeitig in der Lage große kapazitive Lasten mit einer hohen Arbeitsgeschwindigkeit zu treiben.

Der Erfindung liegt nun die Aufgabe zugrunde, eine Tristate-fähige Treiberschaltung anzugeben, bei der die Basis-Emitterstrecke eines Bipolartransistors am Treiberausgang nicht mit beispielsweise der vollen Versorgungsspannung, sondern nur mit einer wesentlich geringeren Spannung in Sperrichtung gepolt wird, wodurch gegebenenfalls eine Zerstörung dieses polartransistors verhindert wird. Diese Aufgabe wird erfindungsgemäß durch die im kennzeichnenden Teil des Patentanspruchs spruchs 1 angegebenen Merkmale gelöst.

Die GB-A 2 249 444 zeigt eine Tristate-fähige Treiberschaltung, mit einem ersten und einem zweiten Bipolartransistor am Treiberausgang. Damit die Basis-Emitterstrecke des oberen Bipolartransistors nicht durch eine Spannung in Sperrichtung zerstört werden kann, ist ein erstes Transmissiongate zwischen Ansteuerschaltung und der Basis des Bipolartransistors sowie ein zweites Transmissiongate zwischen Basis und Emitter des Bipolartransistors vorgesehen. Die Transmissiongates werden von Enable-Signal gesteuert.

Der mit der Erfindung Der erzielbare Vorteil liegt insbesondere darin, daß die Chipfläche im Vergleich zur obengenannten Treiberschaltung nur unwesentlich vergrößert wird und daß durch die erfindungsgemäßen Maßnahmen keine zusätzliche kapazitive Belastung des Treiberausgangs bewirkt wird.

Die Ansprüche 2 bis 9. sind auf bevorzugte Ausbildungen der erfindungsgemäßen Tristate-fähigen Treiberschaltung gerichtet.

Die Erfindung wird nachfolgend anhand der Zeichnung näher erläutert. Dabei zeigt
- Figur 1: ein Schaltbild einer erfindungsgemäßen Treiberschaltung und
- Figur 2: eine alternative Ausführungsform einer in Figur 1 enthaltenen Ansteuerschaltung.

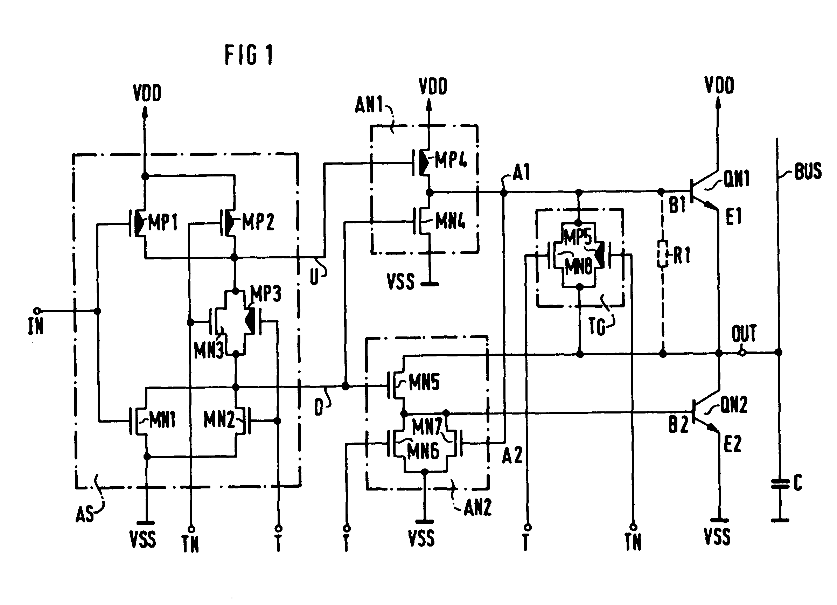

In Figur 1 ist eine erfindungsgemäße Tristate-fähige Treiberschaltung mit einer Auswahlschaltung AS, einer ersten Ansteuerschaltung AN1, einer zweiten Ansteuerschaltung AN2, einem ersten Bipolartransistor QN1, einem zweiten Bipolartransistor QN2 und einem Kurzschluß-Mittel TG dargestellt. Die Auswahlschaltung AS besitzt einen Eingang, der gleichzeitig den Eingang IN der erfindungsgemäßen Treiberschaltung darstellt, einen Tristate-Aktivierungseingang T, einen Eingang TN der das zum Eingang T inverse Signal führt. Die Auswahlschaltung AS ist mit einem Versorgungsspannungsanschluß VDD und einem zugspotentialanschluß VSS verbunden und weist einen ersten Ausgang U und einen zweiten Ausgang D auf.

Die erste Ansteuerschaltung AN1 weist einen ersten Eingang auf, der mit dem ersten Ausgang U der Auswahlschaltung AS verbunden ist, und besitzt einen zweiten Eingang, der mit dem zweiten Ausgang D der Auswahlschaltung AS verbunden ist. Die Ansteuerschaltung AN1 ist mit einem Versorgungsspannungsanschluß VDD und einem Bezugspotentialanschluß VSS verbunden und weist einen Ausgang A1 auf.

Die zweite Ansteuerschaltung AN2 weist einen ersten Eingang auf, der mit dem zweiten Ausgang D der Auswahlschaltung AS verbunden ist und verfügt über einen zweiten Eingang, der mit dem Tristate-Aktivierungseingang T der Treiberschaltung verbunden ist. Ferner ist die zweite Ansteuerschaltung AN2 mit einem Ausgang OUT der Treiberschaltung sowie mit dem Bezugspotentialanschluß VSS beschaltet und besitzt einen Ausgang A2.

Die Basis B1 des ersten Bipolartransistors QN1 ist durch das Signal des Ausgangs A1 der ersten Ansteuerschaltung AN1 und die Basis B2 des zweiten Bipolartransistors QN2 durch das Signal am Ausgang A2 der zweiten Ansteuerschaltung AN2 ansteuerbar. Der Kollektoranschluß des ersten Bipolartransistors QN1 ist mit dem Versorgungsspannungsanschluß VDD und der Kollektor des zweiten Bipolartransistors QN2 ist mit dem Ausgang OUT der Treiberschaltung verbunden. Der Emitter E1 des ersten Bipolartransistors QN1 ist mit dem Ausgang OUT der Treiberschaltung und der Emitter E2 des zweiten Bipolartransistor QN2 ist mit dem Bezugspotentialanschluß VSS beschaltet.

Der Ausgang OUT ist mit einer Busleitung BUS verbunden, die eine Kapazität C gegenüber dem Bezugspotentialanschluß VSS aufweist.

Zwischen der Basis B1 und dem Emitter E1 des ersten Bipolartransistors QN1 ist das Kurzschluß-Mittel TG geschaltet, das durch das Signal am Tristate-Aktivierungseingang T und das dazu inverse Signal ansteuerbar ist.

Zwischen der Basis B1 und dem Emitter E1 des ersten Bipolartransistors QN1 ist ferner ein optional vorhandener Widerstand R1 gestrichelt angedeutet.

Die Auswahlschaltung AS weist jeweils an ihrem ersten Ausgang U eine logische 1 und an ihrem zweiten Ausgang D eine logische 0 auf, sofern am Tristate-Aktivierungseingang T eine logische 1 anliegt und damit der Tristate-Zustand der Treiberschaltung aktiviert ist. Sofern am Tristate-Aktivierungseingang eine logische 0 anliegt, wirkt die Auswahlschaltung AS als Inverterschaltung und sowohl am ersten Ausgang U als auch am zweiten Ausgang D liegt ein Signal an, das gegenüber dem Signal am Eingang IN der Treiberschaltung invertiert ist. Die Auswahlschaltung AS kann beispielsweise mit drei n-Kanal MOS-Transistor MN1 ... MN3 und drei p-Kanal MOS-Transistoren MP1 ... MP3, wie bei Hara et al realisiert sein.

Die Ansteuerschaltung AN1 besteht vorteilhafterweise aus einem p-Kanal MOS-Transistor MP4 und einem n-Kanal MOS-Transistor MN4, wobei das Gate des MOS-Transistors MP4 mit dem ersten Eingang der Ansteuerschaltung, das Gate des MOS-Transistors MN4 mit dem zweiten Eingang der Ansteuerschaltung AN1, ein erster Anschluß des MOS-Transistors MP4 mit dem Versorgungsspannungsanschluß VDD, ein erster Anschluß des MOS-Transistors MN4 mit dem Bezugspotentialanschluß VSS und jeweils ein zweiter Anschluß der MOS-Transistoren MP4 und MN4 verbunden sind und wobei die Verbindungsstelle zwischen den MOS-Transistoren MP4 und MN4 den Ausgang A1 der ersten Ansteuerschaltung AN1 bildet.

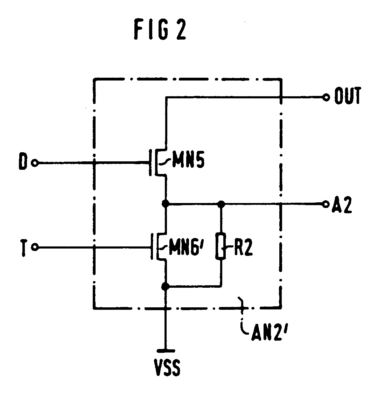

Die Ansteuerschaltung AN2 besitzt beispielsweise drei n-Kanal MOS-Transistoren MN5 ... MN7, die wie bei Hara et al beschaltet sind. In Figur 2 ist alternativ eine weitere zweite Ansteuerschaltung AN2' mit einem ersten n-Kanal MOS-Transistor MN5' und einem zweiten n-Kanal MOS-Transistor MN6' sowie einem Widerstand R2 angegeben. Das Gate des ersten n-Kanal MOS-Transistors MN5' ist dabei mit dem Ausgang D der Auswahlschaltung AS und das Gate des zweiten n-Kanal MOS-Transistors MN6' ist mit dem Tristate-Aktivierungseingang T verbunden. Ein erster Anschluß des ersten MOS-Transistors MN5', des zweiten MOS-Transistors MN6' und des Widerstands R2 ist jeweils mit dem Ausgang A2 der weiteren zweiten Ansteuerschaltung AN2' beschaltet. Der zweite Anschluß des Widerstands R2 und des MOS-Transistors MN6' ist jeweils mit dem Bezugspotentialanschluß VSS und der zweite Anschluß des MOS-Transistors MN5' mit dem Ausgang OUT der Treiberschaltung verbunden.

Das Kurzschlußmittel TG besteht vorteilhafterweise aus einem Übertragungs-Gatter (transfer gate) mit einem n-Kanal MOS-Transistor MN8 und einem dazu parallel geschalteten p-Kanal Transistor MP5, wobei der n-Kanal MOS-Transistor MN8 durch das Signal am Tristate-Aktivierungseingang T und der p-Kanal MOS-Transistor MP5 durch das dazu inverse Signal am Eingang TN ansteuerbar ist.

Ferner kann das Kurzschlußmittel TG nur aus einem der beiden MOS-Transistoren MP5 bzw. MN8 bestehen, der wie vorher beschrieben beschaltet ist, wobei jedoch eine maximale Sperrspannung von ca. 0,7 V zwischen der Basis B1 und dem Emitter E1 auftreten kann.

Der optional vorgesehene Widerstand R1 dient dazu die Sperrspannung im aktiven Zustand der Treiberschaltung, also für T = 0, möglichst klein zu halten, da ohne den Widerstand R1 unter Umständen die Basis B1 wesentlich schneller entladen wird als der Emitter E1 und dies zu einer unzulässig hohen Spannungsbelastung der Basis-Emitter-Strecke führen kann. Der Widerstand R1 kann auch durch einen MOS-Transistor realisiert sein, der mit einem ersten Anschluß mit der Basis B1 und mit einem zweiten Anschluß sowie einem Gateanschluß mit dem Emitter E1 verbunden ist.

Bestünde, wie bei Hara et al, die erste Ansteuerschaltung AN1 aus einem Inverter, wobei der erste und zweite Eingang der ersten Ansteuerschaltung AN1 gleichzeitig mit dem ersten Ausgangssignal U der Auswahlschaltung AS angesteuert würde, und wäre das Kurzschlußmittel TG nicht vorhanden, so würde für den Fall, daß der Ausgang A1 eine logische 0 führt und der Bipolartransistor QN1 sperrt, die Basis-Emitter-Strecke zwischen der Basis B1 und dem Emitter E1 mit einer Sperrspannung belastet, die der Spannung auf der Busleitung entspricht und maximal den Wert der Versorgungsspannung annehmen kann. Der kritische Fall tritt nun auf, wenn beide Bipolartransistoren QN1 und QN2 sperren, der Ausgang OUT also hochohmig (tristate) ist und die Busleitung BUS durch weitere mit der Busleitung verbundene Treiberschaltungen mit einer Spannung beaufschlagt ist, die in etwa der Versorgungsspannung entspricht.

Bei der erfindungsgemäßen Treiberschaltung können im Gegensatz dazu nur geringe Sperrspannungen von beispielsweise 500 mV auftreten. Liegt bei der erfindungsgemäßen Treiberschaltung am Tristate-Aktivierungseingang T eine logische 1, so ergibt sich am ersten Eingang der ersten Ansteuerschaltung AN1 eine logische 1 und am zweiten Eingang der logischen Ansteuerschaltung AN1 eine logisch 0, wodurch der Ausgang der ersten Ansteuerschaltung AN1 hochohmig geschaltet wird, damit der Ausgang A1 der ersten Ansteuerschaltung AN1 nicht durch das Kurzschlußmittel TG kurzgeschlossen wird, da das Kurzschlußmittel TG, für den Fall daß der Tristate-Aktivierungseingang T eine logische 1 führt, durchschaltet. Der erste Bipolartransistor QN1 sperrt, da die Spannung zwischen der Basis B1 und dem Emitter E1 ungefähr Null Volt beträgt und der Bipolartransistor QN2 sperrt, da die Basis B2 durch den MOS-Transistor MN6 bzw. MN6', der durch das Signal des Tristate-Aktivierungseingangs T angesteuert wird, auf das Bezugspotential des Emitters E2 gelegt wird. Für den Fall daß der Tristate-Aktivierungseingang eine logische 0 aufweist, der Treiber also aktiv ist, arbeitet die erste Ansteuerschaltung als invertierender Verstärker und die zweite Ansteuerschaltung als nicht invertierender Verstärker, wodurch die Basis B1 des ersten Bipolartransistors ein Signal erhält, das einem nicht invertierten verstärkten Signal am Eingang IN der Treiberschaltung entspricht und die Basis B2 des zweiten Bipolartransistors QN2 ein Signal erhält, das dem invertierten verstärkten Signal am Eingang IN der Treiberschaltung entspricht. Liegt am Eingang IN eine logische 1, so leitet der erste Bipolartransistor QN1 und sperrt der zweite Bipolartransistor QN2, entsprechend sperrt der erste Bipolartransistor QN1 und leitet der zweite Bipolartransistor QN2, sobald das Signal am Eingang IN1 einer logischen 0 entspricht.

Die erfindungsgemäße Treiberschaltung entspricht also im aktiven Zustand einer nicht invertierenden Treiberschaltung.

Moderne BiCMOS-Technologien verdanken ihre hohe Schaltgeschwindigkeit unter anderem einer optimierten Dotierverteilung in der Basis und im Emitter. Hierbei kommen zunehmend flachere Dotierprofile mit entsprechend größeren Dotiergradienten zum Einsatz. Für eine Emitter-Basis-Strecke (-Diode) mit derartigen Dotierprofilen existiert nun eine maximal zulässige Sperrspannung, die unter dem Wert der Versorgungsspannung liegen kann. Da die erfindungsgemäße Treiberschaltung das Auftreten einer unzulässig hohen Sperrspannung verhindert, kann die erfindungsgemaße Treiberschaltung beispielsweise bevorzugt bei Hochgeschwindigkeitsanwendungen mit einer Versorgungsspannung von größer gleich 3 Volt verwendet werden. Hochgeschwindigkeitsanwendungen bedeuten in diesem Zusammenhang typischerweise Gatterlaufzeiten von 1 ns bei 1 pF Last.

## Patentansprüche

1. Tristate-fähige Treiberschaltung,
- mit einer Auswahlschaltung (AS), die mit einem Versorgungsspannungsanschluß (VDD) und einem Bezugspotentialanschluß (VSS) verbunden ist und bei der ein erster Ausgang (U) der Auswahlschaltung eine logische 1 und ein zweiter Ausgang (D) der Auswahlschaltung eine logische 0 führt, sofern an einem Tristate-Aktivierungseingang (T) eine logische 1 anliegt, und der erste und zweite Ausgang der Auswahlschaltung ein zum Signal am Eingang (IN) der Treiberschaltung inverses Signal führen, sofern am Tristate-Aktivierungseingang eine logische 0 anliegt,
- mit einer ersten Ansteuerschaltung (AN1), die mit dem sorgungsspannungsanschluß (VDD), dem Bezugspotentialanschluß (VSS) und an einem ersten Eingang mit dem ersten Ausgang (U) der Auswahlschaltung verbunden ist,
- mit einer zweiten Ansteuerschaltung (AN2), die mit dem sorgungsspannungsanschluß (VDD) und dem zweiten Ausgang (D) der Auswahlschaltung verbunden ist und bei der ein Ausgang (A2) der zweiten Ansteuerschaltung eine logische 0 aufweist, sofern am Tristate-Aktivierungseingang (T) eine logische 1 anliegt, und der Ausgang (A2) der zweiten Ansteuerschaltung ein zum Signal am Eingang (IN) der Treiberschaltung inverses Signal aufweist, sofern am Tristate-Aktivierungseingang(T) eine logische 0 anliegt,
- mit einem ersten Bipolartransistor (QN1) eines ersten Typs dessen Basis (B1) mit dem Ausgang (A1) der ersten Ansteuerschaltung (AN1) dessen Kollektor mit dem Versorgungsspannungsanschluß (VDD) und dessen Emitter (E1) mit einem Ausgang (OUT) der Treiberschaltung verbunden sind, und
- mit einem zweiten Bipolartransistor (QN2) des ersten Typs, dessen Basis (B2) mit dem Ausgang (A2) der zweiten Ansteuerschaltung (AN2), dessen Kollektor mit dem Ausgang (OUT) der Treiberschaltung und dessen Emitter (E2) mit dem zugspotentialanschluß (VSS) verbunden sind,
**dadurch gekennzeichnet,**
- daß die erste Ansteuerschaltung einen zweiten Eingang besitzt, der mit dem zweiten Ausgang (D) der Auswahlschaltung verbunden ist,
- daß ein Ausgang (A1) der ersten Ansteuerschaltung hochohmig ist, sofern am ersten Eingang der ersten Ansteuerschaltung eine logische 1 und gleichzeitig am zweiten Eingang der ersten Ansteuerschaltung eine logische 0 anliegt, und der Ausgang (A1) der ersten Ansteuerschaltung ein zum Signal am Eingang (IN) der Treiberschaltung nicht invertiertes Signal führt, sofern an beiden Eingängen der ersten Ansteuerschaltung gleichzeitig entweder eine logische 0 oder eine logische 1 anliegt, und
- daß ein Kurzschluß-Mittel (TG) vorgesehen ist, das die Basis (B1) des ersten Bipolartransistors (QN1) und den Emitter (I1) des ersten Bipolartransistors kurzschließt, sofern am Tristate-Aktivierungseingang (T) eine logische 1 anliegt und die Basis des ersten Bipolartransistors vom Emitter des ersten Bipolartransistors hochohmig trennt, sofern am Tristate-Aktivierungseingang eine logische 0 anliegt.

2. Tristate-fähige Treiberschaltung nach Anspruch 1,
**dadurch gekennzeichnet,**
- daß das Kurzschluß-Mittel aus einem Übertragungs-Gatter besteht,
- daß das Übertragungsgatter einen ersten n-Kanal MOS-Transistor (MN8) und einen ersten p-Kanal MOS-Transistor (MP5) aufweist,
- daß jeweils ein erster Anschluß der beiden MOS-Transistoren mit der Basis (B1) des ersten Bipolartransistors und jeweils ein zweiter Anschluß der beiden ersten MOS-Transistoren mit dem Emitter (E1) des ersten Bipolartransistors verbunden sind und
- daß der Gateanschluß des ersten n-Kanal MOS-Transistors mit dem Tristate-Aktivierungseingang (T) und der Gateanschluß des ersten p-Kanal MOS-Transistors mit einem Eingang (TN) verbunden ist, der ein zum Signal des Tristate-Aktivierungseingangs invertiertes Signal führt.

3. Tristate-fähige Treiberschaltung nach Anspruch 1,
**dadurch gekennzeichnet,**
daß das Kurzschluß-Mittel nur aus einem ersten n-Kanal-MOS-Transistor (MNS) besteht, dessen erster Anschluß mit der Basis (B1) des ersten Bipolartransistors, dessen zweiter Anschluß mit dem Emitter (E1) des ersten Bipolartransistors und dessen Gateanschluß mit dem Tristate-Aktivierungseingang (T) verbunden sind.

4. Tristate-fähige Treiberschaltung nach Anspruch 1,
**dadurch gekennzeichnet,**
daß das Kurzschluß-Mittel nur aus einem ersten p-Kanal-MOS-Transistor (MP5) besteht, dessen erster Anschluß mit der Basis (B1) des ersten Bipolartransistors, dessen zweiter Anschluß mit dem Emitter (E1) des ersten Bipolartransistors und dessen Gateanschluß mit einem Eingang verbunden ist, der ein zum Tristate-Aktivierungseingang (T) inverses Signal führt.

5. Tristate-fähige Treiberschaltung nach einem der Ansprüche 1 bis 4,
**dadurch gekennzeichnet,**
- daß die erste Ansteuerschaltung (AN1) aus einem zweiten p-Kanal MOS-Transistor (MP4) und einem zweiten n-Kanal MOS-Transistor (MN4) besteht,
- daß das Gate des zweiten p-Kanal-MOS-Transistors mit dem ersten Eingang der ersten Ansteuerschaltung und das Gate des zweiten n-Kanal MOS-Transistors mit dem zweiten Eingang der ersten Ansteuerschaltung verbunden ist,
- daß ein erster Anschluß des zweiten p-Kanal MOS-Transistors mit dem Versorgungsspannungsanschluß (VDD) und ein erster Anschluß des zweiten n-Kanal MOS-Transistors mit einem zugspotentialanschluß (VSS) verbunden ist und
- daß ein zweiter Anschluß des zweiten p-Kanal MOS-Transistors und ein zweiter Anschluß des zweiten n-Kanal MOS-Transistors verbunden sind und die Verbindungsstelle den Ausgang (A1) der ersten Ansteuerschaltung (AN1) bildet.

6. Tristate-fähige Treiberschaltung nach einem der Ansprüche 1 bis 5,
**dadurch gekennzeichnet,**
- daß die zweite Ansteuerschaltung (AN2) einen dritten (MN5), einen vierten (MN6) und einen fünten n-Kanal MOS-Transistor (MN7) aufweist,
- daß der Gateanschluß des dritten n-Kanal MOS-Transistors mit dem zweiten Ausgang (D) der Auswahlschaltung, der Gateanschluß des vierten n-Kanal MOS-Transistors mit dem Tristate-Aktivierungseingang(T) und der Gateanschluß des fünften n-Kanal MOS-Transistors mit dem Ausgang (A1) der ersten Ansteuerschaltung verbunden sind,
- daß ein erster Anschluß des dritten n-Kanal MOS-Transistors mit dem Ausgang (OUT) der Treiberschaltung und ein zweiter Anschluß des dritten n-Kanal MOS-Transistors mit dem Ausgang (A2) der zweiten Ansteuerschaltung verbunden sind und
- daß jeweils ein erster Anschluß des vierten und fünften n-Kanal MOS-Transistors mit dem Ausgang (A2) der zweiten steuerschaltung und jeweils ein zweiter Anschluß des vierten und fünften n-Kanal MOS-Transistors mit dem Bezugspotentialanschluß(VSS) verbunden sind.

7. Tristate-fähige Treiberschaltung nach einem der Ansprüche 1 bis 5,
**dadurch gekennzeichnet,**
- daß die zweite Ansteuerschaltung (AN2) einen dritten (MN5') und einen vierten n-Kanal MOS-Transistor (MN6') sowie einen Widerstand (R2) aufweist,
- daß der Gateanschluß des dritten n-Kanal MOS-Transistors mit dem zweiten Ausgang (D) der Auswahlschaltung und der Gateanschluß des vierten n-Kanal MOS-Transistors mit dem Tristate-Aktivierungseingang (T) verbunden sind,
- daß ein erster Anschluß des dritten n-Kanal MOS-Transistors mit dem Ausgang (OUT) der Treiberschaltung und ein zweiter Anschluß des dritten n-Kanal MOS-Transistors mit dem Ausgang (A2) der zweiten Ansteuerschaltung verbunden sind und
- daß jeweils ein erster Anschluß des vierten n-Kanal MOS-Transistors und des Widerstandes mit dem Ausgang (A2) der zweiten Ansteuerschaltung und jeweils ein zweiter Anschluß des vierten n-Kanal Transistors und des Widerstandes mit dem Bezugspotentialanschluß verbunden sind.

8. Tristate-fähige Treiberschaltung nach einem der vorhergehenden Ansprüche,
**dadurch gekennzeichnet,**
daß zusätzlich zum Kurzschlußmittel ein Widerstand (R1) vorgesehen ist, der mit einem ersten Anschluß mit der Basis (B1) des ersten Bipolartransistors und mit einem zweiten Anschluß mit dem Emitter (E1) des ersten Bipolartransistors verbunden ist.

9. Tristate-fähige Treiberschaltung nach Anspruch 8,
**dadurch gekennzeichnet,**
daß der zusätzlich zum Kurzschlußmittel vorgesehene Widerstand durch einen MOS-Transistor gebildet wird, dessen erster Anschluß mit der Basis (B1) des ersten Bipolartransistors und dessen zweiter Anschluß und Gateanschluß mit dem Emitter (E1) des ersten Bipolartransistors verbunden sind.

## Claims

1. Driver circuit with tristate capability,
- having a selection circuit (AS), which is connected to a supply voltage terminal (VDD) and a reference potential terminal (VSS) and in the case of which a first output (U) of the selection circuit carries a logic 1 and a second output (D) of the selection circuit carries a logic 0 provided that a logic 1 is present at a tristate activation input (T), and the first and second outputs of the selection circuit carry a signal which is the inverse of the signal at the input (IN) of the driver circuit, provided that a logic 0 is present at the tristate activation input,
- having a first drive circuit (AN1), which is connected to the supply voltage terminal (VDD), the reference potential terminal (VSS) and, at a first input, to the first output (U) of the selection circuit,
- having a second drive circuit (AN2), which is connected to the supply voltage terminal (VDD) and the second output (D) of the selection circuit and in the case of which an output (A2) of the second drive circuit has a logic 0 provided that a logic 1 is present at the tristate activation input (T), and the output (A2) of the second drive circuit has a signal which is the inverse of the signal at the input (IN) of the driver circuit, provided that a logic 0 is present at the tristate activation input (T),
- having a first bipolar transistor (QN1) of a first type, whose base (B1) is connected to the output (A1) of the first drive circuit (AN1), whose collector is connected to the supply voltage terminal (VDD) and whose emitter (E1) is connected to an output (OUT) of the driver circuit, and
- having a second bipolar transistor (QN2) of the first type, whose base (B2) is connected to the output (A2) of the second drive circuit (AN2), whose collector is connected to the output (OUT) of the driver circuit and whose emitter (E2) is connected to the reference potential terminal (VSS),
characterized
- in that the first drive circuit has a second input, which is connected to the second output (D) of the selection circuit,
- in that an output (A1) of the first drive circuit has a high impedance, provided that a logic 1 is present at the first input of the first drive circuit and, at the same time, a logic 0 is present at the second input of the first drive circuit, and the output (A1) of the first drive circuit carries a signal which is not inverted with respect to the signal at the input (IN) of the driver circuit, provided that either a logic 0 or a logic 1 is simultaneously present at both inputs of the first drive circuit, and
- in that a short-circuiting means (TG) is provided which short-circuits the base (B1) of the first bipolar transistor (QN1) and the emitter (I1) of the first bipolar transistor, provided that a logic 1 is present at the tristate activation input (T), and isolates the base of the first bipolar transistor from the emitter of the first bipolar transistor at high impedance, provided that a logic 0 is present at the tristate activation input.

2. Driver circuit with tristate capability according to Claim 1, characterized
- in that the short-circuiting means comprises a transfer gate,
- in that the transfer gate has a first n-channel MOS transistor (MN8) and a first p-channel MOS transistor (MP5),
- in that a first terminal of each of the two MOS transistors is connected to the base (B1) of the first bipolar transistor and a second terminal of each of the two first MOS transistors is connected to the emitter (E1) of the first bipolar transistor, and
- in that the gate terminal of the first n-channel MOS transistor is connected to the tristate activation input (T) and the gate terminal of the first p-channel MOS transistor is connected to an input (TN) which carries a signal which is inverted with respect to the signal of the tristate activation input.

3. Driver circuit with tristate capability according to Claim 1, characterized in that the short-circuiting means comprises just one first n-channel MOS transistor (MN8), whose first terminal is connected to the base (B1) of the first bipolar transistor, whose second terminal is connected to the emitter (E1) of the first bipolar transistor and whose gate terminal is connected to the tristate activation input (T).

4. Driver circuit with tristate capability according to Claim 1, characterized in that the short-circuiting means comprises just one first p-channel MOS transistor (MP5), whose first terminal is connected to the base (B1) of the first bipolar transistor, whose second terminal is connected to the emitter (E1) of the first bipolar transistor and whose gate terminal is connected to an input which carries an inverse signal with respect to the tristate activation input (T).

5. Driver circuit with tristate capability according to one of Claims 1 to 4, characterized
- in that the first drive circuit (AN1) comprises a second p-channel MOS transistor (MP4) and a second n-channel MOS transistor (MN4),
- in that the gate of the second p-channel MOS transistor is connected to the first input of the first drive circuit and the gate of the second n-channel MOS transistor is connected to the second input of the first drive circuit,
- in that a first terminal of the second p-channel MOS transistor is connected to the supply voltage terminal (VDD) and a first terminal of the second n-channel MOS transistor is connected to a reference potential terminal (VSS), and
- in that a second terminal of the second p-channel MOS transistor and a second terminal of the second n-channel MOS transistor are connected to one another and the junction point forms the output (A1) of the first drive circuit (AN1).

6. Driver circuit with tristate capability according to one of Claims 1 to 5, characterized
- in that the second drive circuit (AN2) has a third n-channel MOS transistor (MN5), a fourth n-channel MOS transistor (MN6) and a fifth n-channel MOS transistor (MN7),
- in that the gate terminal of the third n-channel MOS transistor is connected to the second output (D) of the selection circuit, the gate terminal of the fourth n-channel MOS transistor is connected to the tristate activation input (T) and the gate terminal of the fifth n-channel MOS transistor is connected to the output (A1) of the first drive circuit,
- in that a first terminal of the third n-channel MOS transistor is connected to the output (OUT) of the driver circuit and a second terminal of the third n-channel MOS transistor is connected to the output (A2) of the second drive circuit, and
- in that a first terminal of each of the fourth and fifth n-channel MOS transistors is connected to the output (A2) of the second drive circuit and a second terminal of each of the fourth and fifth n-channel MOS transistors is connected to the reference potential terminal (VSS).

7. Driver circuit with tristate capability according to one of Claims 1 to 5, characterized
- in that the second drive circuit (AN2) has a third n-channel MOS transistor (MN5') and a fourth n-channel MOS transistor (MN6') as well as a resistor (R2),
- in that the gate terminal of the third n-channel MOS transistor is connected to the second output (D) of the selection circuit and the gate terminal of the fourth n-channel MOS transistor is connected to the tristate activation input (T),
- in that a first terminal of the third n-channel MOS transistor is connected to the output (OUT) of the driver circuit and a second terminal of the third n-channel MOS transistor is connected to the output (A2) of the second drive circuit, and
- in that a first terminal both of the fourth n-channel MOS transistor and of the resistor is connected to the output (A2) of the second drive circuit and a second terminal both of the fourth n-channel transistor and of the resistor is connected to the reference potential terminal.

8. Driver circuit with tristate capability according to one of the preceding claims, characterized in that a resistor (R1) is provided in addition to the short-circuiting means, a first terminal of which resistor is connected to the base (B1) of the first bipolar transistor and a second terminal of which resistor is connected to the emitter (E1) of the first bipolar transistor.

9. Driver circuit with tristate capability according to Claim 8, characterized in that the resistor which is provided in addition to the short-circuiting means is formed by an MOS transistor, whose first terminal is connected to the base (B1) of the first bipolar transistor and whose second terminal and gate terminal are connected to the emitter (E1) of the first bipolar transistor.

## Revendications

1. Circuit d'attaque capable de prendre trois états
- comprenant un circuit de sélection (AS) qui est relié à une borne de tension d'alimentation (VDD) et à une borne de potentiel de référence (VSS), et dans lequel une première sortie (U) du circuit de sélection est dans un état logique "1" et une seconde sortie (D) du circuit de sélection est dans un état logique "0" dans la mesure où un niveau logique "1" est appliqué à une entrée d'activation à trois états (T), et les première et seconde sorties du circuit de sélection conduisent un signal inverse par rapport au signal à l'entrée (IN) du circuit d'attaque dans la mesure où un niveau logique "0" est appliqué à l'entrée d'activation à trois états,
- comprenant un premier circuit de commande (AN1) qui est relié à la borne de tension d'alimentation (VDD), à la borne de potentiel de référence (VSS) et, au niveau d'une première entrée, à la première sortie (U) du circuit de sélection,
- comprenant un second circuit de commande (AN2) qui est relié à la borne de tension d'alimentation (VDD) et à la seconde sortie (D) du circuit de sélection, et dans lequel une sortie (A2) du second circuit de commande présente un état logique "0" dans la mesure où un niveau logique "1" est appliqué à l'entrée d'activation à trois états (T), et la sortie (A2) du second circuit de commande présente un signal inverse par rapport au signal à l'entrée (IN) du circuit d'attaque dans la mesure où un niveau logique "0" est appliqué à l'entrée d'activation à trois états (T),
- comprenant un premier transistor bipolaire (QN1) d'un premier type, dont la base (B1) est reliée à la sortie (A1) du premier circuit de commande (AN1), dont le collecteur est relié à la borne de tension d'alimentation (VDD) et dont l'émetteur (E1) est relié à une sortie (OUT) du circuit d'attaque, et
- comprenant un second transistor bipolaire (QN2) du premier type, dont la base (B2) est reliée à la sortie (A2) du second circuit de commande (AN2), dont le collecteur est relié à la sortie (OUT) du circuit d'attaque et dont l'émetteur (E2) est relié à la borne de potentiel de référence (VSS),
caractérisé
- en ce que le premier circuit de commande possède une seconde entrée qui est reliée à la seconde sortie (D) du circuit de sélection,
- en ce qu'une sortie (A1) du premier circuit de commande présente une résistance élevée dans la mesure où un niveau logique "1" est appliqué à la première entrée du premier circuit de commande et où, simultanément, un niveau logique "0" est appliqué à la seconde entrée du premier circuit de commande, et en ce que la sortie (A1) du premier circuit de commande conduit un signal non inversé par rapport au signal à l'entrée (IN) du circuit d'attaque dans la mesure où, aux deux entrées du premier circuit de commande, est appliqué simultanément, soit un niveau logique "0", soit un niveau logique "1", et
- en ce que l'on prévoit un moyen de court-circuit (TG) qui court-circuite la base (B1) du premier transistor bipolaire (QN1) et l'émetteur (I1) du premier transistor bipolaire dans la mesure où un niveau logique "1" est appliqué à l'entrée d'activation à trois états (T), et qui sépare la base du premier transistor bipolaire de l'émetteur du premier transistor bipolaire par une résistance élevée dans la mesure où un niveau logique "0" est appliqué à l'entrée d'activation à trois états.

2. Circuit d'attaque capable de prendre trois états selon la revendication 1,
caractérisé
- en ce que le moyen de court-circuit est formé par une porte de transmission,
- en ce que la porte de transmission comprend un premier transistor MOS à canal N (MN8) et un premier transistor MOS à canal P (MP5),
- en ce qu'une première borne respective des deux transistors MOS est reliée à la base (B1) du premier transistor bipolaire et une seconde borne respective des deux premiers transistors MOS est reliée à l'émetteur (E1) du premier transistor bipolaire, et
- en ce que la borne de grille du premier transistor MOS à canal N est reliée à l'entrée d'activation à trois états (T) et la borne de grille du premier transistor MOS à canal P est reliée à une entrée (TN) qui conduit un signal inversé par rapport au signal de l'entrée d'activation à trois états.

3. Circuit d'attaque capable de prendre trois états selon la revendication 1, caractérisé en ce que le moyen de court- circuit est formé seulement d'un premier transistor MOS à canal N (MNS) dont la première borne est reliée à la base (B1) du premier transistor bipolaire, dont la seconde borne est reliée à l'émetteur (E1) du premier transistor bipolaire et dont la borne de grille est reliée à l'entrée d'activation à trois états (T).

4. Circuit d'attaque capable de prendre trois états selon la revendication 1,
caractérisé en ce que le moyen de court- circuit est formé seulement d'un premier transistor MOS à canal P (MP5) dont la première borne est reliée à la base (B1) du premier transistor bipolaire, dont la seconde borne est reliée à l'émetteur (E1) du premier transistor bipolaire et dont la borne de grille est reliée à une entrée qui conduit un signal inverse à celui de l'entrée d'activation à trois états (T).

5. Circuit d'attaque capable de prendre trois états selon l'une des revendications 1 à 4,
caractérisé
- en ce que le premier circuit de commande (AN1) est formé d'un second transistor MOS à canal P (MP4) et d'un second transistor MOS à canal N (MN4),
- en ce que la grille du second transistor MOS à canal P est reliée à la première entrée du premier circuit de commande et la grille du second transistor MOS à canal N est reliée à la seconde entrée du premier circuit de commande,
- en ce qu'une première borne du second transistor MOS à canal P est reliée à la borne de tension d'alimentation (VDD) et une première borne du second transistor MOS à canal N est reliée à une borne de potentiel de référence (VSS), et
- en ce qu'une seconde borne du second transistor MOS à canal P et une seconde borne du second transistor MOS à canal N sont reliées et le point de jonction forme la sortie (A1) du premier circuit de commande (AN1).

6. Circuit d'attaque capable de prendre trois états selon l'une des revendications 1 à 5,
caractérisé
- en ce que le second circuit de commande (AN2) comprend un troisième (MN5), un quatrième (MN6) et un cinquième transistor MOS à canal N (MN7),
- en ce que la borne de grille du troisième transistor MOS à canal N est reliée à la seconde sortie (D) du circuit de sélection, la borne de grille du quatrième transistor MOS à canal N est reliée à l'entrée d'activation à trois états (T) et la borne de grille du cinquième transistor MOS à canal N est reliée à la sortie (A1) du premier circuit de commande,
- en ce qu'une première borne du troisième transistor MOS à canal N est reliée à la sortie (OUT) du circuit d'attaque et une seconde borne du troisième transistor MOS à canal N est reliée à la sortie (A2) du second circuit de commande, et
- en ce qu'une première borne respective des quatrième et cinquième transistors MOS à canal N est reliée à la sortie (A2) du second circuit de commande et une seconde borne respective des quatrième et cinquième transistors MOS à canal N est reliée à la borne de potentiel de référence (VSS).

7. Circuit d'attaque capable de prendre trois états selon l'une des revendications 1 à 5,
caractérisé
- en ce que le second circuit de commande (AN2) comprend un troisième (MN5') et un quatrième transistor MOS à canal N (MN6'), ainsi qu'une résistance (R2),
- en ce que la borne de grille du troisième transistor MOS à canal N est reliée à la seconde sortie (D) du circuit de sélection et la borne de grille du quatrième transistor MOS à canal N est reliée à l'entrée d'activation à trois états (T),
- en ce qu'une première borne du troisième transistor MOS à canal N est reliée à la sortie (OUT) du circuit d'attaque et une seconde borne du troisième transistor MOS à canal N est reliée à la sortie (A2) du second circuit de commande, et
- en ce qu'une première borne respective du quatrième transistor MOS à canal N et de la résistance est reliée à la sortie (A2) du second circuit de commande et une seconde borne respective du quatrième transistor à canal N et de la résistance est reliée à la borne de potentiel de référence.

8. Circuit d'attaque capable de prendre trois états selon l'une des revendications précédentes,
caractérisé en ce que l'on prévoit, en plus du moyen de court-circuit, une résistance (R1) qui est reliée, par une première borne, à la base (B1) du premier transistor bipolaire et, par une seconde borne, à l'émetteur (E1) du premier transistor bipolaire.

9. Circuit d'attaque capable de prendre trois états selon la revendication 8,
caractérisé en ce que la résistance prévue en plus du moyen de court-circuit est formée par un transistor MOS dont la première borne est reliée à la base (B1) du premier transistor bipolaire et dont la seconde borne et la borne de grille sont reliées à l'émetteur (E1) du premier transistor bipolaire.
